(19) Europäisches Patentamt
European Patent Office
Office européen des brevets

(11) **EP 4 040 485 A1**

(12) **EUROPEAN PATENT APPLICATION**

(43) Date of publication:
**10.08.2022 Bulletin 2022/32**

(21) Application number: **21213438.1**

(22) Date of filing: **09.12.2021**

(51) International Patent Classification (IPC):
***H01L 25/075*** *(2006.01)*

(52) Cooperative Patent Classification (CPC):
**H01L 25/0753;** H01L 2933/0083; H01L 2933/0091

| | |
|---|---|
| (84) Designated Contracting States:<br>**AL AT BE BG CH CY CZ DE DK EE ES FI FR GB GR HR HU IE IS IT LI LT LU LV MC MK MT NL NO PL PT RO RS SE SI SK SM TR**<br>Designated Extension States:<br>**BA ME**<br>Designated Validation States:<br>**KH MA MD TN**<br><br>(30) Priority: **03.02.2021 US 202163145150 P**<br>**04.05.2021 KR 20210058127**<br><br>(71) Applicant: **Samsung Electronics Co., Ltd.**<br>**Suwon-si, Gyeonggi-do 16677 (KR)** | (72) Inventors:<br>• **HWANG, Junsik**<br>**16678, Suwon-si, (KR)**<br>• **HONG, Seogwoo**<br>**16678, Suwon-si, (KR)**<br>• **HWANG, Kyungwok**<br>**16678, Suwon-si, (KR)**<br>• **KIM, Hyunjoon**<br>**16678, Suwon-si, (KR)**<br>• **PARK, Joonwong**<br>**16678, Suwon-si, (KR)**<br><br>(74) Representative: **Elkington and Fife LLP**<br>**Prospect House**<br>**8 Pembroke Road**<br>**Sevenoaks, Kent TN13 1XR (GB)** |

(54) **DISPLAY TRANSFERRING STRUCTURE AND DISPLAY DEVICE INCLUDING THE SAME**

(57) A display transferring structure includes a transferring substrate including a mold including a plurality of recesses, and a plurality of protrusions provided on an outer surface of the mold connected to the plurality of recesses; and micro semiconductor chips arranged in the recesses. When the micro semiconductor chips are wet aligned, by such protrusions, sliding of the micro semiconductor chips toward the inside of the recesses may be improved.

FIG. 1

# Description

FIELD OF THE INVENTION

The disclosure relates to a display transferring structure and a display device including the same.

BACKGROUND OF THE INVENTION

Recently, light-emitting diodes (LEDs) are in high demand because of the LEDs have low power consumption and environmental friendliness. As such, the LEDs are applied to pixels of display devices, in addition to being used as lighting apparatuses or LCD backlights. In preparing display devices using micro LED chips, a pick and place method is used for transferring micro LEDs. However, the productivity of such a method is reduced as the sizes of the micro LEDs are reduced and the sizes of the displays are increased.

SUMMARY OF THE INVENTION

Provided are a display transferring structure allowing micro semiconductor chips to be effectively arranged on a large-area substrate, and a display device using the display transferring structure.

Additional aspects will be set forth in part in the description which follows and, in part, will be apparent from the description, or may be learned by practice of the embodiments of the disclosure.

According to an example embodiment, there is provided a display transferring apparatus including: a transferring substrate including a mold including a plurality of recesses, and a plurality of protrusions provided on an outer surface of the mold, the outer surface being connected to the plurality of recesses; and a plurality of micro semiconductor chips respectively provided in the plurality of recesses.

A width of each of the plurality of protrusions may be less than a width of each of the plurality of micro semiconductor chips.

A space between adjacent protrusions among the plurality of protrusions may be less than a width of each of the plurality of micro semiconductor chips.

The space between adjacent protrusions among the plurality of protrusions, which is defined as s, may satisfy a condition: $s \leq (w1-w2)/2$, wherein, w1 is the width of each micro semiconductor chip and w2 is the width of each of the protrusions, respectively.

The plurality of protrusions may include a different material from a material of the mold.

The plurality of protrusions may include a metal material.

Areas between the plurality of protrusions may be filled with a first material that is different from a second material of the plurality of protrusions.

he protrusions and the mold may include a same material and are integrated.

The protrusions may be defined by a plurality of concave patterns recessed from the outer surface of the mold.

Depths of the concave patterns may be the same as depths of the recesses.

The plurality of protrusions may be formed by roughing the outer surface of the mold.

The display transferring apparatus may include a driving circuit configured to drive the micro semiconductor chips.

The driving circuit may be provided inside the transferring substrate.

The display transferring apparatus may further include a circuit board provided under the transferring substrate and including the driving circuit.

According to another example embodiment, there is provided a display device including: a transferring substrate including a mold including a plurality of recesses, and a plurality of protrusions provided on an outer surface of the mold, the outer surface being connected to the plurality of recesses; a plurality of micro semiconductor chips provided in the recesses; a driving circuit configured to drive the plurality of micro semiconductor chips; and a color conversion layer provided on the transferring substrate.

The driving circuit may be provided inside the transferring substrate.

The display device may further include a circuit board provided under the transferring substrate and including the driving circuit.

A width of each of the protrusions may be less than a width of each of the micro semiconductor chips.

The protrusions may include a metal material.

The protrusions and the mold may include a same material and the protrusions and the mold are integrated.

According to another example embodiment, there is provided an electronic apparatus including the display device.

According to another example embodiment, there is provided a display transferring apparatus including: a transferring substrate including: a plurality of recesses on an upper surface of the transferring substrate, each of the plurality of recesses configured to receive an electronic component; and a plurality of protrusions provided on the upper surface of the transferring substrate, wherein a first width of each of the plurality of protrusions is smaller than a second width of the electronic component, and wherein a distance between a first protrusion and a second protrusion adjacent to the first protrusion is smaller than the second width of the electronic component.

BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 is a schematic perspective view of a display transferring structure according to an example embodiment;

FIG. 2 is an enlarged cross-sectional view of a part of FIG. 1;

FIG. 3 is a conceptual view explaining a space requirement between protrusions provided on a transferring substrate of the display transferring structure of FIG. 1 in relation to the sizes of micro semiconductor chips;

FIG. 4 is a conceptual view showing an example of inappropriate space between the protrusions provided on the transferring substrate according to a comparative example;

FIG. 5 is a diagram illustrating a process of forming the display transferring structure of FIG. 1;

FIG. 6 is a micrograph showing a manufactured display transferring structure of FIG. 1;

FIG. 7 is a micrograph showing a manufactured display transferring structure according to a comparative example;

FIG. 8 is a schematic cross-sectional view of a display transferring structure according to another example embodiment;

FIG. 9 is a schematic cross-sectional view of a display transferring structure according to another example embodiment;

FIG. 10 is a schematic cross-sectional view of a display transferring structure according to an example embodiment;

FIG. 11 shows micro semiconductor chips provided on a display transferring structure being transferred to a thin-film transistor (TFT) substrate;

FIG. 12 is a schematic cross-sectional view of a display transferring structure according to another example embodiment;

FIG. 13 is a schematic cross-sectional view of a display transferring structure according to another example embodiment;

FIG. 14 is a schematic cross-sectional view of a display transferring structure according to another example embodiment;

FIG. 15 is a schematic cross-sectional view of a display device according to an example embodiment; and

FIG. 16 is a schematic block diagram showing an electronic apparatus according to an example embodiment.

DETAILED DESCRIPTION

Reference will now be made in detail to embodiments, examples of which are illustrated in the accompanying drawings, wherein like reference numerals refer to like elements throughout. In this regard, the example embodiments may have different forms and should not be construed as being limited to the descriptions set forth herein. Accordingly, the example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, example embodiments will be described in detail with reference to the accompanying drawings. Meanwhile, example embodiments described below are provided only as an example, and thus can be embodied in various forms. In the drawings, like reference numerals demote like elements, and sizes of each component are exaggerated for clarity and convenience in explanation.

It will be understood that when a component is referred to as being "on" or "on the top of" another component, the component can be directly on, under, on the left of, or on the right of the other component, or can be on, under, on the left of, or on the right of the other component in a non-contact manner.

The terms 'first', 'second,' etc. may be used to describe various elements but are only used herein to distinguish one element from another element. The terms do not define that the components have different materials or structures from each other.

As used herein, the singular forms "a," "an" and "the" are intended to include the plural forms as well, unless the context clearly indicates otherwise. Throughout the specification, when a portion "includes" an element, another element may be further included, rather than excluding the existence of the other element, unless otherwise described.

In addition, the terms such as ".. unit", "module", etc. provided herein indicates a unit performing at least one function or operation, and may be realized by hardware, software, or a combination of hardware and software.

As used herein, in particular, terms such as "the" and demonstratives similar thereto used herein may be to indicate both the singular and the plural.

Unless explicitly stated that operations of a method should be performed in an order described below, the operations may be performed in an appropriate order. The use of any and all examples, or example language (e.g., "such as") provided herein, is intended merely to better illuminate the disclosure and does not pose a limitation on the scope of the disclosure unless otherwise claimed.

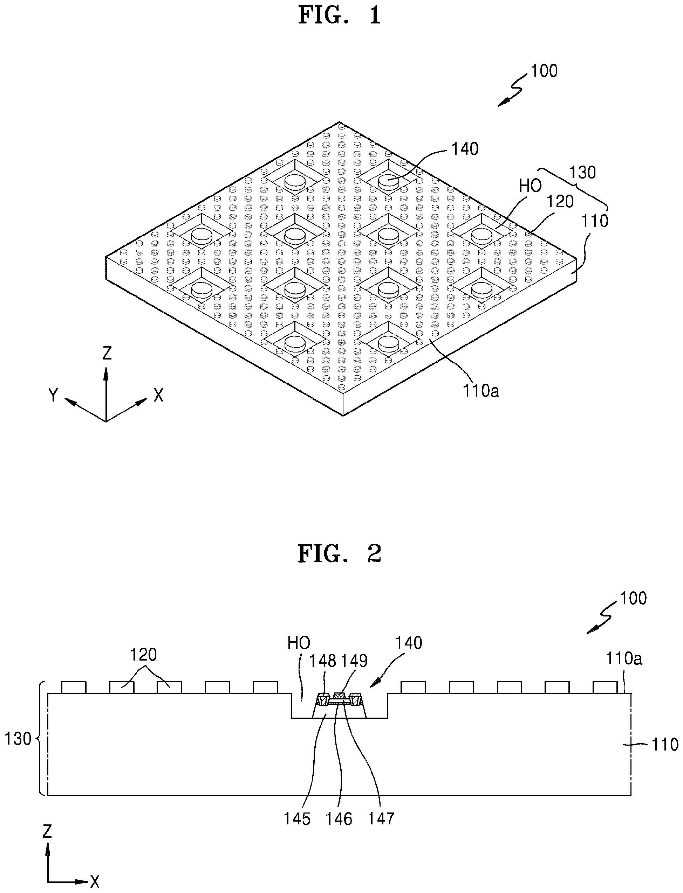

FIG. 1 is a schematic perspective view of a display transferring structure according to an example embodiment, and FIG. 2 is an enlarged cross-sectional view of a part of FIG. 1.

A display transferring structure 100 may include a transferring substrate 130 and micro semiconductor chips 140 respectively arranged in recesses HO of the transferring substrate 130. The transferring substrate 130 may include a mold 110 including the plurality of recesses HO and a plurality of protrusions 120 provided on an outer surface 110a of the mold 110, the outer surface 110 being connected to the plurality of recesses HO. According to an example embodiment, the outer surface 110a may be the upper surface of the mold 110. According to an example embodiment, the protrusions 120 may be formed on an upper surface of the mold 110. The protrusions 120 may be formed integrally on the mold 110 or separately formed on the upper surface of th mold 110. According to an example embodiment, the protrusions may be convex patterns. However, the disclosure is not limited thereto, and the protrusions may have a different shape. For instance, the protrusions may have a polyhedron shape such as a cylindrical shape or a cube shape.

The transferring substrate 130, which is for arranging the micro semiconductor chips 140 in a fluid self-alignment (FSA) method, may include the mold 100 including the plurality of recesses HO for aligning the plurality of micro semiconductor chips 140, and the plurality of protrusions 120 formed on the outer surface 110a of the mold 100.

The micro semiconductor chips 140 may include various semiconductor chips having micro sizes, and micro sizes may be 1,000 $\mu$m or less, 200 $\mu$m or less, 100 $\mu$m or less, or 50 $\mu$m or less. The micro semiconductor chips 140 may include, for example, a light-emitting diode (LED), a complementary metal-oxide semiconductor (CMOS), a CMOS image sensor (CIS), a vertical-cavity surface-emitting laser (VCSEL), a photodiode (PD), a memory device, or a two-dimensional (2D) material device. The 2D material may be a graphene or carbon nanotubes (CNTs). In the following description, the micro-semiconductor chips 140 may be described as LED chips, but are not limited thereto.

Referring to the specific structure of the micro semiconductor chips 140 shown in FIG. 2 as an example, the micro semiconductor chips 140 may include an n-type semiconductor layer 145, an activation layer 146, or a p-type semiconductor layer 147. The n-type semiconductor layer 145 may include n-type GaN and the p-type semiconductor layer 147 may include p-type GaN, but are not limited thereto. The activation layer 146 may have, for example, a quantum well structure or a multiquantum well structure. A first electrode 148 and a second electrode 149 may be arranged on the micro semiconductor chips 140. The first electrode 148 may be electrically connected to the n-type semiconductor layer 145, and the second electrode 149 may be electrically connected to the p-type semiconductor layer 147. The specific forms of the micro semiconductor chips 140 are examples and are not limited thereto.

A cross-sectional shape of the micro-semiconductor chips 140 is illustrated as a circle, but is not limited thereto, and may be, for example, rectangular. In addition, a shape of the recesses HO is illustrated as a rectangle, but is not limited thereto, and may be, for example, circular or oval.

The protrusions 120 are provided to lower the surface energy of the outer surface 110a of the mold 110, the outer surface 110a being connected to the recesses HO, to prevent the micro semiconductor chips 140 from being fixed on the outer surface 110a of the mold 110. For example, when the micro semiconductor chips 140 dispersed in a predetermined suspension are supplied onto the transferring substrate 130, and when the micro semiconductor chips 140 are bonding-fixed on the outer surface 110a of the mold 110, not entering the recesses HO, a cleaning process for removing the micro semiconductor chips 140 may be required. In addition, normally, because pressure processing for fixing the micro semiconductor chips 140 entered in the recesses HO is performed before the cleaning process, removing the micro semiconductor chips 140 that are fixed on the outer surface 110a of the mold 110 is not easy and may degrade yield. Generally, the surface energy of the interface between two surfaces is proportional to the contact area, and therefore, when protrusions 120 are provided, the surface energy of the interface between the bottom surface of the micro semiconductor chips 140 and the transferring substrate 130 may decrease, and the micro semiconductor chips 140 may easily be transferred into the recesses HO.

A width of the protrusions 120 and a space between the protrusions 120 may be set such that the micro semiconductor chips 140 are not fixed on the protrusions 120 or the outer surface 110a of the mold 110 and the path toward the recesses HO is not obstructed by the protrusions 120. The cross-sectional shape of the protrusions 120 is illustrated as a circle, but this is an example. The protrusions 120 may be changed to have a polygonal shape, an annular shape, an oval shape, or any other shape.

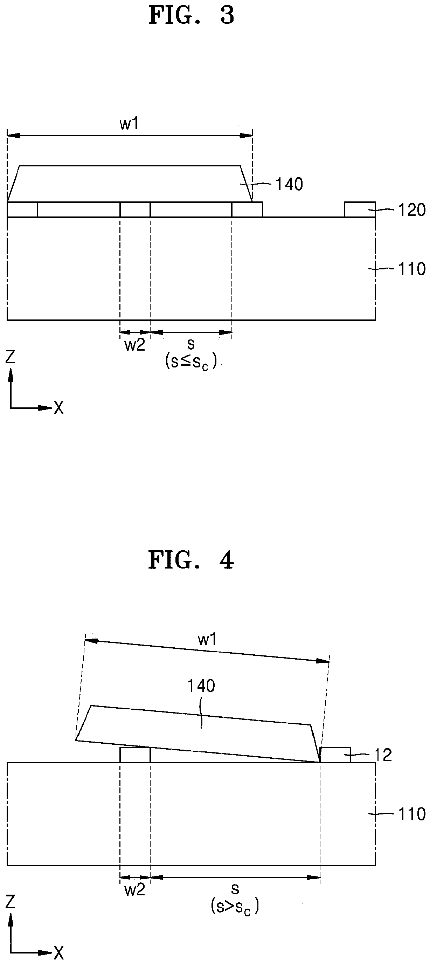

FIG. 3 is a conceptual view explaining a space requirement between protrusions provided on the transferring substrate of the display transferring structure of FIG. 1 in relation to the sizes of micro semiconductor chips.

A width w2 of each of the protrusions 120 may be less than a width w1 of each of the micro semiconductor chips 140. To lower the surface energy of the interface between the protrusions 120 and the micro semiconductor chips 140, the width w2 of each convex pattern 120 may be set to be, for example, 50 % or less, 30 % or less, or 10 % or less of each micro semiconductor chip 140.

In addition, the space s between adjacent protrusions 120 may be set to be less than the width w1 of each micro semiconductor chip 140. Even when the space s between adjacent protrusions 120 is less than the width w1 of each micro semiconductor chip 140, there may be a case when both ends of each micro semiconductor chip 140 are each caught in the upper portion and the lower portion of the adjacent protrusions 120, making it impossible for the micro semiconductor chip 140 to be moved toward the recess HO. To prevent such a phenomenon, a maximum value $s_c$ of the space s between adjacent protrusions 120 may be set.

Thus, s, which is the space between adjacent protrusions, may satisfy the following condition.

$$s \leq s_c = (w1-w2)/2$$

Such a requirement of the space s and widths w1 and w2 is also applied to directions other than the illustrated direction. That is, w1 may be a width in any direction of the bottom surface of the micro semiconductor chip 140, and the width w2 and space s between the protrusions 120 may be a width and a space in not only the X direction, as illustrated, but also in any direction in a plane perpendicular to the Z direction.

The space s between the protrusions 120 may be set to be equal to or less than the maximum value $s_c$, 90 % of Sc or less, 80 % of Sc or less, or 50 % of Sc or less.

A height of the protrusions 120 is not particularly limited, and may be set to be similar to, equal to, or less than a height of the micro semiconductor chips 140.

FIG. 4 is a conceptual view showing an example of inappropriate space between the protrusions provided on the transferring substrate according to a comparative example.

When the space between protrusions 12 does not satisfy the above condition and is greater than $s_c$, both ends of the micro semiconductor chip 140 may each be caught in the upper portion and lower portion of the adjacent protrusions 12 and it may be difficult for the micro semiconductor chip 140 to be moved into the recess HO.

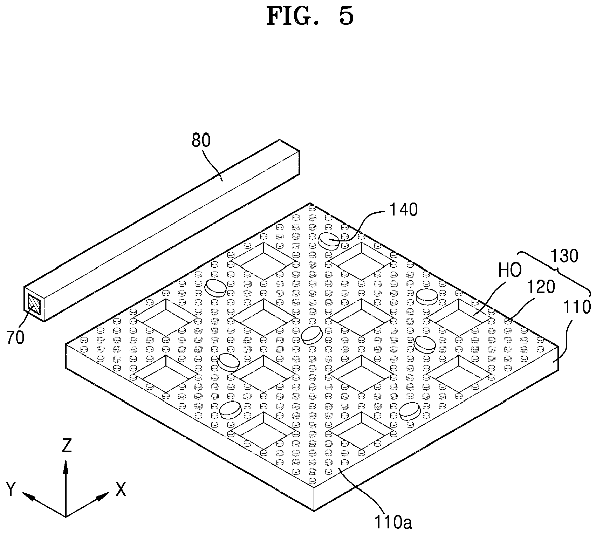

FIG. 5 is a diagram for explaining a process of forming the display transferring structure of FIG. 1.

FIG. 5 shows a state wherein the plurality of micro semiconductor chips 140 are provided on the transferring substrate 130, which includes the mold 110 including the recesses HO and the protrusions 120 formed on the outer surface 110a of the mold 110. The plurality of micro semiconductor chips 140 may be directly sprayed on the transferring substrate 130 after supplying a predetermined liquid to the recesses HO of the transferring substrate 130, or may be supplied on the transferring substrate 130 while being included in a predetermined suspension.

According to an example embodiment, liquid supplied to the recesses HO may be any type of liquid. However, liquids that may corrodes or damages the micro semiconductor chips 140 may not be supplied to the recesses HO. According to an example embodiment, various methods such as spraying, dispensing, inkjet dotting, and flowing liquid to the transferring substrate 130 may be used. Liquid may include, for example, at least one of or multiple combinations of water, ethanol, alcohol, polyol, ketone, halocarbon, acetone, flux, and an organic solvent. An organic solvent may include, for example, isopropyl alcohol (IPA).

The plurality of micro semiconductor chips 140 may be directly sprayed on the transferring substrate 130 without other liquids, or may be supplied on the transferring substrate 130 while being included in a suspension.

An absorbent material 80 may scan the transferring substrate 130. By the scanning, the absorbent material 80 may move the micro semiconductor chips 140 into the recesses HO while being in contact with the transferring substrate 130 and passing through the plurality of recesses HO, and may absorb liquid in the recesses HO. A material capable of absorbing liquid is sufficient for an absorbent material 80, and the form or structure of the absorbent material 80 is not limited. The absorbent material 80 may include, for example, fabric, tissue, polyester fibers, paper, wipers, and the like. Although the absorbent material 80 may be used alone without other auxiliary equipment, one or more example embodiments are not limited thereto, and may be coupled to a support 70 for convenient scanning of the transferring substrate 130. The support 70 may have various forms or structures suitable for scanning the transferring substrate 130. The support 70 may have the form of, for example, a load, a blade, a plate, or a wiper. The absorbent material 80 may be provided on any one surface of the support 70 or may be wrapped around the support 70. The cross-sectional shape of the absorbent material 80 and the support 70 may not only be limited to a square but may also be a circle.

The absorbent material 80 may scan the transferring substrate 130 while pressing at an appropriate pressure. Scanning may be performed by the absorbent material 80 through various methods such as a sliding method, a rotating method, a translating movement method, a reciprocating movement method, a rolling method, a spinning method, and/or a rubbing method, and may include both regular and irregular methods. Scanning may be performed by moving the transferring substrate 130 instead of the absorbent material 80, and scanning of the transferring substrate 130 may also be performed by methods such as sliding, rotating, translational reciprocating, rolling, spinning, and/or rubbing. Scanning may also be performed by a cooperation of the absorbent material 80 and the transferring substrate 130.

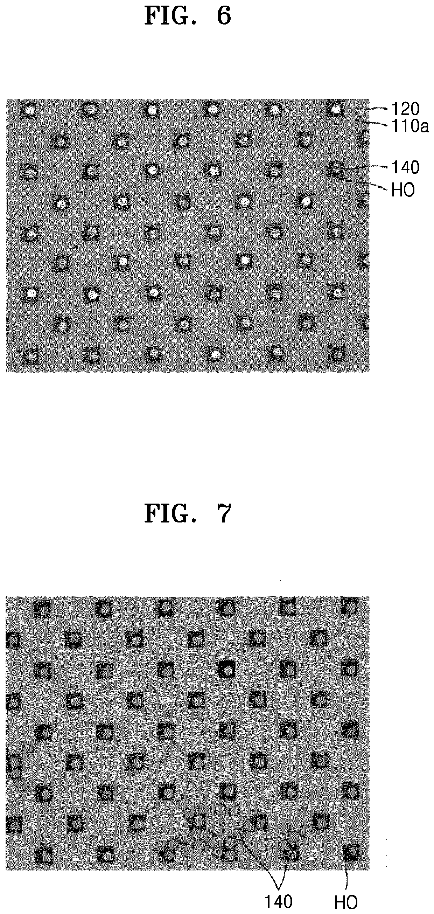

FIG. 6 is a micrograph showing the manufactured display transferring structure of FIG. 1.

It can be seen that the micro semiconductor chips 140 are only inside the recesses HO and do not remain in other positions. Such a manufacturing process was performed by changing the occupancy of the protrusions 120, that is, the fill factor, which is the ratio of the area occupied by the protrusions 120 relative to the total area of the outer surface 110a connected to the recesses HO, to 25 %, 45 %, and 71 %. The protrusions 120 prevents the micro semiconductor chips 140 from being pressed in another position, thereby improving sliding and spreading efficiency. As a result, a clean state of 99.9% or more are shown at positions excluding the recesses HO.

FIG. 7 is a micrograph showing a manufactured display transferring structure according to a comparative example.

In the display transferring structure according to a comparative example, which was manufactured using a transferring substrate 130 not including the protrusions 120, it may be seen that the plurality of micro semiconductor chips 140 remain on the surface of the transferring substrate 130, not the recesses HO.

In the display transferring structure 100 described above, although the mold 110 and the protrusions 120 in the transferring substrate 130 were exemplified to include different materials, the mold 100 and the protrusions 120 may include the same material and may be integrated.

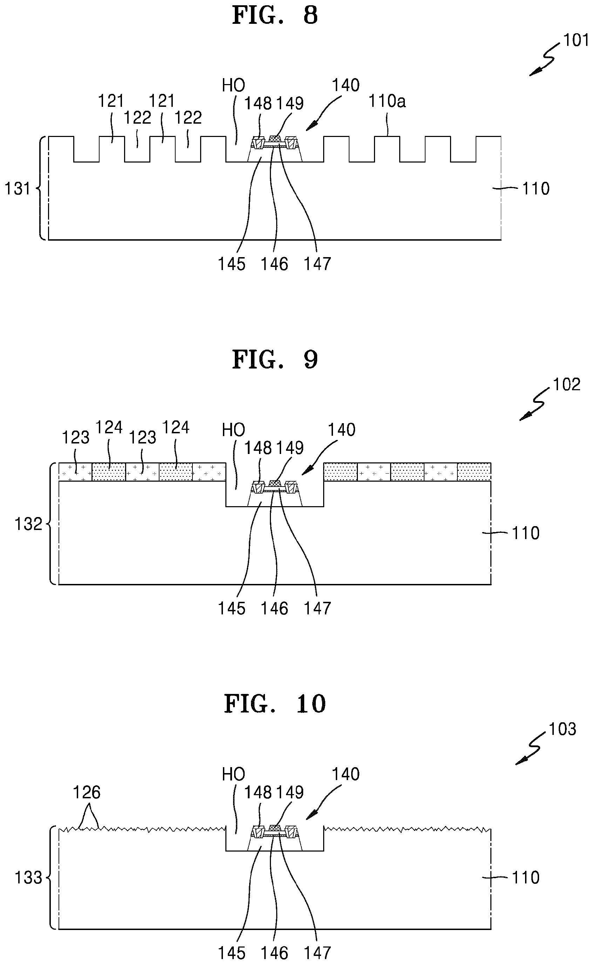

FIG. 8 is a schematic cross-sectional view of a display transferring structure according to another example embodiment.

A display transferring structure 101 of the example embodiment illustrated in FIG. 8 may be different from the display transferring structure 100 illustrated in FIGS. 1 and 2 described above, in that, a transferring substrate 131 includes a mold 110 including recesses HO and a plurality of protrusions 121 that are integrated with the mold 110.

According to an example embodiment, the protrusions 121 may be defined by a plurality of recess patterns 122 recessed from an outer surface 110a of the mold 110. According to an example embodiment, the recess patterns 122 may be concave patterns. However, the disclosure is not limited thereto, and as such, according to another example embodiment, the recess pattern may have a different shape. The depth of the recess patterns 122 may be the same as the depth of the recesses HO, in which case the protrusions 121 may be formed together when the mold 110 is manufactured. However, the depth of the recess patterns 122 is not limited thereto, and may be different from the depth of the recesses HO.

FIG. 9 is a schematic cross-sectional view of a display transferring structure according to another example embodiment.

A display transferring structure 102 of the example embodiment differs from the display transferring structure 100 of FIG. 1 in that a transferring substrate 132 includes a plurality of first patterns 123 on the outer surface of a mold 110 including the recesses HO and a plurality of second patterns 124 provided between the plurality of first patterns 123 and including a different material from a material of the first patterns 123.

The first patterns 123 may alternate with the second patterns 124, forming a flat surface as a whole. Any one of the materials that form the first patterns 123 and the second patterns 124 may be a hydrophilic material and the other may be a hydrophobic material. The first patterns 123 and the second patterns may have a convex shape. However, the disclosure is not limited thereto, and as such, according to another example embodiment, the first patterns 123 and the second patterns may have a different shape.

FIG. 10 is a schematic cross-sectional view of a display transferring structure according to another example embodiment.

In a display transferring structure 103 according to an example embodiment, a transferring substrate 133 may include a mold 110 including a recess HO and protrusions 126 on the surface of the mold 110, wherein the protrusions 126 may be formed by roughing the surface of the mold 110. Although the protrusions 126 are illustrated to be integrated with the mold 110, one or more example embodiments are not limited thereto, and after forming a metal layer on the mold 110, the protrusions 126 may be formed by roughing the surface of the metal layer.

The display transferring structures 100, 101, 102, and 103 described above may be applied to a display device using the micro-semiconductor chips 140. The plurality of micro semiconductor chips 140 provided in the display transferring structures 100, 101, 102, and 103 may include a plurality of LED chips emitting red light (R), green light (G), and blue light (B), or only a plurality of LED chips emitting blue light (B). Such display transferring structures 100, 101, 102, and 103 may be applied to a display device wherein the plurality of micro semiconductor chips 140 operate as individual pixels, for example, an RGB self-emissive micro LED TV. In this case, the display transferring structures 100, 101, 102, and 103 may be used as a display device as a whole, or the micro semiconductor chips 140 provided on the display transferring structures 100, 101, 102, and 103 may be bonding transferred (eutectic bonding) to the thin-film transistor (TFT) substrate.

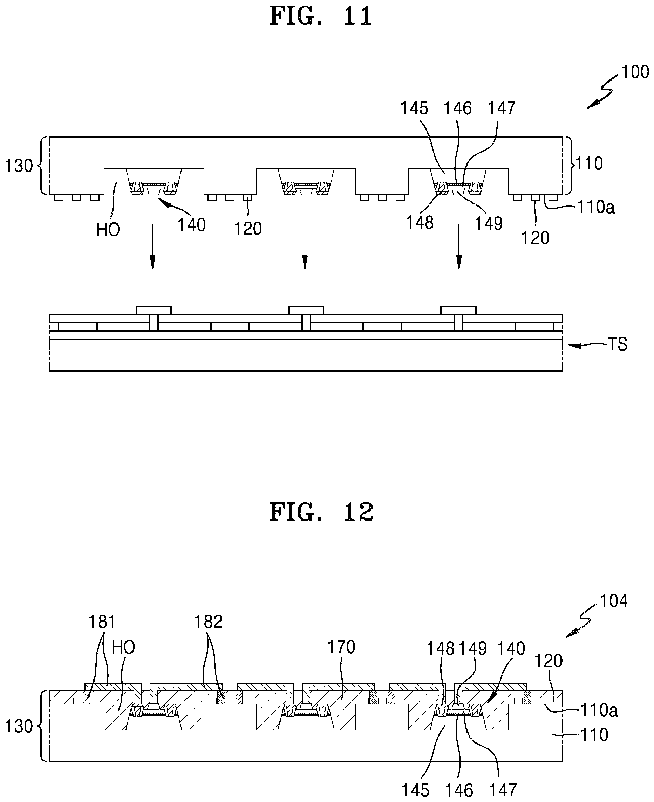

FIG. 11 shows micro semiconductor chips which are provided on a display transferring structure being transferred to a TFT substrate.

As illustrated, a display transferring structure 100 may act as a transferring mold for transferring micro semiconductor chips 140 to another position. The micro semiconductor chips 140 may be transferred by bonding to a TFT substrate TS including a driving circuit such as a TFT that drives the micro semiconductor chips 140. Because the micro semiconductor chips 140 are appropriately positioned inside recesses HO through protrusions 120 formed on an outer surface 110a of a mold 110 including the recesses HO, the micro semiconductor chips 140 may be transferred appropriately on the predetermined position of the TFT substrate TS. After the micro semiconductor chips 140 are bonded and transferred on the TFT substrate TS, the display device may be completed through an additional process. Although the display transferring structure 100 is exemplified in FIG. 11, the display transferring structures 101, 102, and 103 may be used as transferring molds. By using the display transferring structures 100, 101, 102, and 103, the manufacturing yield of the display device may be improved.

The display transferring structures 100, 101, 102, and 103 may each be applied directly as a display device. Example embodiments of FIGS. 12 to 14 exemplify a display transferring structure further including an additional structure so that the display transferring structure can be directly applied to the display device.

FIG. 12 is a schematic cross-sectional view of a display transferring structure according to another example embodiment.

A display transferring structure 104 of the example embodiment may have a form that further includes an additional material layer in the display transferring structure 100 of FIG. 1.

The display transferring structure 104 may further include an insulating layer 170 formed inside recesses HO, and circuit elements 181 and 182 connected to first electrodes 148 and second electrodes 149 of micro semiconductor chips 140. Circuit elements 181 and 182 may constitute a part of a driving circuit which drives the micro semiconductor chips 140.

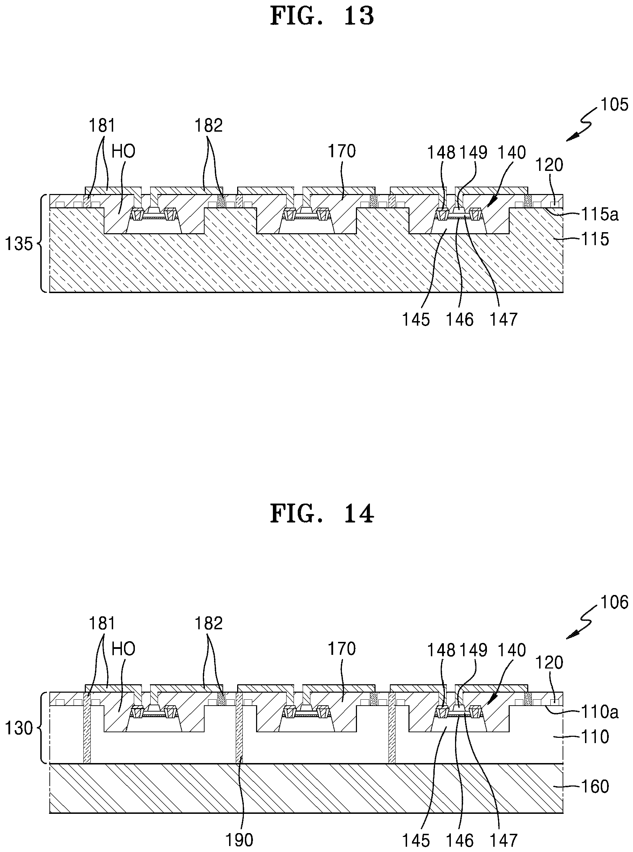

FIG. 13 is a schematic cross-sectional view of a display transferring structure according to another example embodiment.

A display transferring structure 105 of the example embodiment differs from the display transferring structure 104 previously described in that a circuit board 115 including a driving circuit which drives micro semiconductor chips 140 is used as a transferring substrate 135. Circuit elements such as a driving transistor, a switch transistor, and a capacitor may be provided inside the circuit board 115. Recesses HO may be formed in the circuit board 115, and a plurality of protrusions 120 may be provided on an outer surface 115a of the circuit board 115 including the recesses HO, and thus, micro semiconductor chips 140 may be aligned inside the recesses HO by a wet alignment method. Therefore, the additional process is minimized and the display transferring structure 105 may be used as the display device.

FIG. 14 is a schematic cross-sectional view of the display transferring structure according to another example embodiment.

A display transferring structure 106 of the example embodiment may include a circuit board 160 arranged under a transferring substrate 130. Circuit elements such as a driving transistor, a switch transistor, and a capacitor may be provided in the circuit board 160, and the circuit elements of the circuit board 160 may be electrically connected with micro semiconductor chips 140 through conductive vias 190 that penetrate a mold 110.

Although the display transferring structures 104, 105, and 106 of FIGS. 12 to 14 are exemplified as including the protrusions 120 with the same form as those provided on the display transferring structure 100 of FIG. 1, one or more example embodiments are not limited thereto, and may be changed to include the protrusions 121, 124, and 126 exemplified in FIGS. 8 to 10.

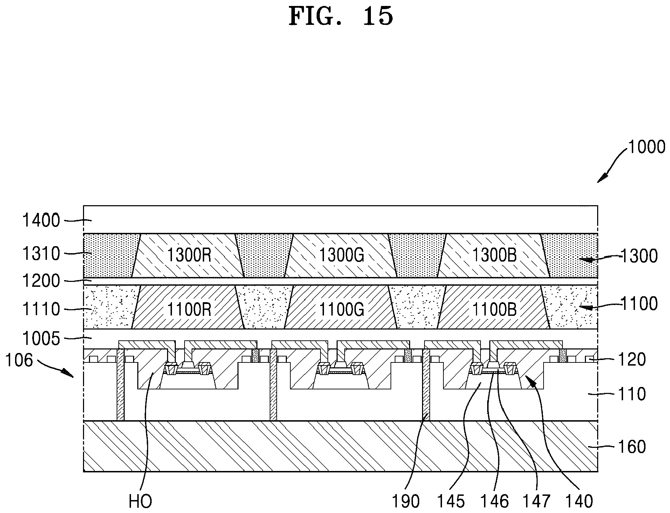

FIG. 15 is a schematic cross-sectional view of the display device according to an example embodiment.

A display device 1000 may include a display transferring structure 106, and a color conversion layer 1100 arranged on the display transferring structure 106. The display transferring structure 106 may include a mold 110 including recesses HO and protrusions 120 formed on the surface of the mold 110 and micro semiconductor chips 140 arranged in recesses HO.

Although the display transferring structure 106 is illustrated as exemplified in FIG. 14, one or more example embodiments are not limited thereto, and may be changed to the display transferring structure 104 of FIG. 12, the display transferring structure 105 of FIG. 13, or forms changed therefrom.

A passivation layer 1005 including an insulating material may be arranged on the display transferring structure 106, and the color conversion layer 1100 may be arranged on the passivation layer 1005.

The color conversion layer 1100 may include a first color conversion layer 1100B configured to convert light from the micro semiconductor chips 140 to first color light, a second color conversion layer 1100G configured to convert light to second color light, and a third color conversion layer 1100R configured to convert light to third color light. The first color light may be, for example, blue light, the second color light may be, for example, green light, and the third color light may be, for example, red light. The first color conversion layer 1100B, the second color conversion layer 1100G, and the third color conversion layer 1100R may be apart from each other with a partition wall 1110 therebetween, and each of the layers may be arranged to face the micro semiconductor chips 140.

When the micro semiconductor chips 140 emit blue light, the first color conversion layer 1100B may include a resin which transmits blue light. The second color conversion layer 1100G may convert blue light emitted from the micro semiconductor chips 140 to emit green light. The second color conversion layer 1100G may include: quantum dots (QDs) excited by blue light from the micro semiconductor chips 140 to emit green light. According to another example embodiment, The third color conversion layer 1100R may include phosphor. The third color conversion layer 1100R may convert blue light emitted from the micro semiconductor chips 140 to emit red light. The third color conversion layer 1100R may include: QDs excited by blue light emitted from the micro semiconductor chips 140 to emit red light. According to another example embodiment, The third color conversion layer 1100R may include phosphor.

The QDs included in the second color conversion layer 1100G and the third color conversion layer 1100R may have a core-shell structure having a core portion and a shell portion, or may have a particle structure without a shell. The core-shell structure may be a single-shell structure or a multi-shell structure, for example, a double-shell structure. The QD may include a group II-VI semiconductor, a group III-V semiconductor, a group IV-VI semiconductor, a group IV semiconductor, and/or a graphene QD. The QD may, for example, include Cd, Se, Zn, S and/or InP, and each of the QDs may have a diameter of less than tens of nm or less, for example, about 10 nm or less. The QDs included in the second color conversion layer 1100G and the third color conversion layer 1100R may have different sizes.

A capping layer 1200 may be arranged on the color conversion layer 1100, and a color filter layer 1300 may be arranged on the capping layer 1200. The color filter layer 1300 may include a first filter 1300B, a second filter 1300G, and a third filter 1300R apart from each other with a black matrix 1310 therebetween. The first filter 1300B, the second filter 1300G, and the third filter 1300R may be arranged to respectively face the first color conversion layer 1100B, the second color conversion layer 1100G, and the third color conversion layer 1100R. The first filter 1300B, the second filter 1300G, and the third filter 1300R may each transmit blue light, green light, and red light, and absorb light of other colors. The color filter layer 1300 may be omitted. When the color filter layer 1300 is provided, light emitted without color conversion from the second color conversion layer 1100G, that is, light other than green light, or light emitted without color conversion from the third color conversion layer 1100R, that is, light other than red light, may each be filtered in the second filter 1300G and the third filter 1300R, thereby increasing color purity.

A protective substrate 1400 made of transparent material may be arranged on the color conversion layer 1100.

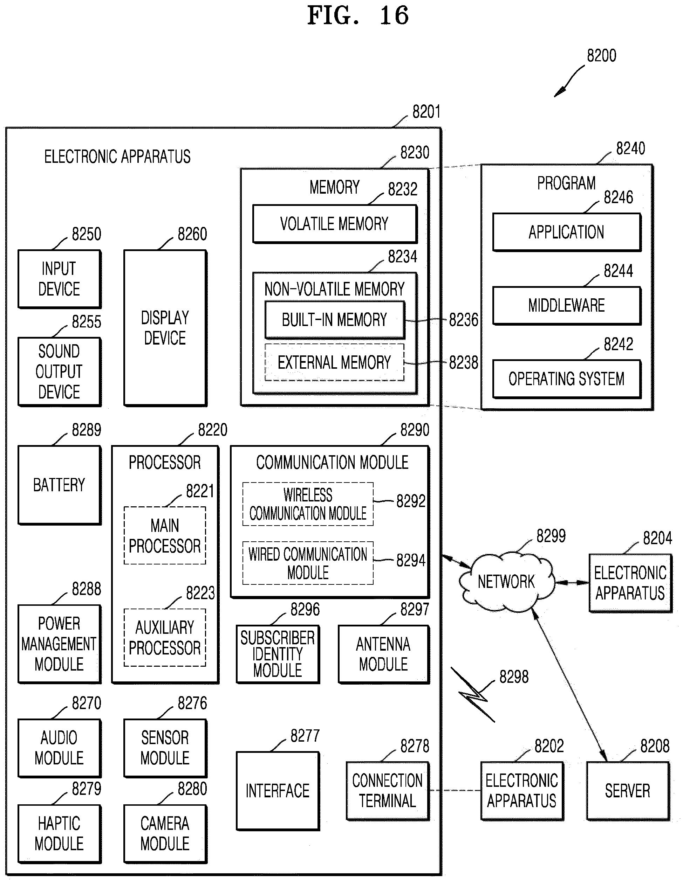

FIG. 16 is a schematic block diagram showing an electronic apparatus according to an example embodiment.

Referring to FIG. 16, an electronic apparatus 8201 may be provided in a network environment 8200. In the network environment 8200, the electronic apparatus 8201 may communicate with another electronic apparatus 8202 through a first network 8298 (near-field communication, etc.) or may communicate with another electronic apparatus 8204 and/or server 8208 through a second network 8299 (far-field communication). The electronic apparatus 8201 may communicate with the electronic apparatus 8204 through the server 8208. The electronic apparatus 8201 may include a processor 8220, a memory 8230, an input device 8250, a sound output device 8255, a display device 8260, and audio module 8270, a sensor module 8276, an interface 8277, a haptic module 8279, a camera module 8280, a power management module 8288, a battery 8289, a communication module 8290, a subscriber identity module 8296, and/or an antenna module 8297. In the electronic apparatus 8201, some of these components may be excluded, or other components may be added. Some of these components may be implemented as one integrated circuit. For example, the sensor module 8276 (a fingerprint sensor, an iris sensor, an illuminance sensor, etc.) may be embedded in the display device 8260 (display, etc.).

The processor 8220 may execute software (a program 8240) to control one of the electronic apparatuses 8201 connected to the processor 8220 or a plurality of other components (hardware, software components, etc.), and various data processing or operations may be performed. As part of data processing or operations, the processor 8220 may load the commands and/or data received from other components (the sensor module 8276, the communication module 8290, etc.) to a volatile memory 8232, process the commands and/or data stored in the volatile memory 8232, and store the resulting data in a non-volatile memory 8234. The processor 8220 may include a main processor 8221 (a central processing unit, an application processor, etc.), and an auxiliary processor 8223 (a graphics processing device, an image signal processor, a sensor hub processor, a communication processor, etc.) that may be used independently or together with the main processor 8221. The auxiliary processor 8223 may use less power than the main processor 8221, and may perform a specialized function.

The auxiliary processor 8223 may control the function and/or status related to part of the components of the electronic apparatus 8201 instead of the main processor 8221 when the main processor 8221 is in an inactive state (sleep state), or together with the main processor 8221 when the main processor 8221 is in an active state (application execution state). The auxiliary processor 8223 (the image signal processor, the communication processor, etc.) may be implemented as part of another functionally related component (the camera module 8280, the communication module 8290, etc.).

The memory 8230 may store various data required by the components (the processor 8220, the sensor module 8276) of the electronic apparatus 8201. The data may include, for example, the software (the program 8240, etc.), and input data and/or output data regarding commands related thereto. The memory 8230 may include the volatile memory 8232 and/or the non-volatile memory 8234.

The program 8240 may be stored in the memory 8230 as software, and may include an operating system 8242, middleware 8244, and/or an application 8246.

The input apparatus 8250 may receive commands and/or data to be used in the components (the processor 8220, etc.) of the electronic apparatus 8201 from outside (the user, etc.) the electronic apparatus 8201. The input apparatus 8250 may include a remote controller, a microphone, a mouse, a keyboard, and/or a digital pen (stylus pen).

The sound output apparatus 8255 may output the sound signal to the outside of the electronic apparatus 8201. The sound output apparatus 8255 may include a speaker and/or a receiver. The speaker may be used for general purposes such as multimedia playing or record playing, and the receiver may be used for receiving an incoming call. The receiver may be incorporated as a part of the speaker or implemented as an independent separate apparatus.

The display device 8260 may visually provide information to the outside of the electronic apparatus 8201. The display device 8260 may include a display, a hologram apparatus, or a projector, and a control circuit for controlling the corresponding apparatus. The display device 8260 may be the display device 1000 described with reference to FIG. 15, or may be the display device including the display transferring structure illustrated in FIGS. 1, 8 to 10, and 12 to 14. The display device 8260 may include touch circuitry set to sense a touch, and/or a sensor circuit (a pressure sensor, etc.) set to measure the intensity of a force generated by the touch.

The audio module 8270 may convert sound to an electric signal, or convert the electric signal to sound. The audio module 8270 may obtain sound through the input apparatus 8250, or may print sound through the speaker and/or a headphone of another electronic apparatus (the electronic apparatus 8202, etc.), which is directly or wirelessly connected to the sound output apparatus 8255 and/or the electronic apparatus 8201.

The sensor module 8276 may sense an operating state (power, temperature, etc.) of the electronic apparatus 8201 or an external environment state (user state, etc.) and may generate an electrical signal and/or data value corresponding to the sensed state. The sensor module 8276 may include a gesture sensor, a gyro sensor, a pressure sensor, a magnetic sensor, an acceleration sensor, a grip sensor, a proximity sensor, a color sensor, an infrared (IR) sensor, a biometric sensor, a temperature sensor, a humidity sensor, and/or an illuminance sensor.

The interface 8277 may support one or more predetermined protocols that may be used for directly or wirelessly connecting the electronic apparatus 8201 to another electronic apparatus (the electronic apparatus 8202, etc.). The interface 8277 may include a High Definition Multimedia Interface (HDMI), a Universal Serial Bus (USB) interface, an SD card interface, and/or an audio interface.

A connection terminal 8278 may include a connector that may physically connect the electronic apparatus 8201 with another electronic apparatus (the electronic apparatus 8202, etc.). The connection terminal 8278 may include an HDMI connector, a USB connector, an SD card connector, and/or an audio connector (a headphone connector, etc.).

The haptic module 8279 may convert the electric signal to a mechanical signal (vibration, movement, etc.) which may be recognized by the user through tactile sense or kinesthetics. The haptic module 8279 may include a motor, a piezoelectric effect element, and/or an electric stimulation device.

The camera module 8280 may capture still images and movies. The camera module 8280 may include lens assemblies including one or more lenses, image sensors, image signal processors, and/or flashes. The lens assembly included in the camera module 8280 may collect light emitted from the subject for image capturing.

The power management module 8288 may manage power supplied to the electronic apparatus 8201. The power management module 8288 may be implemented as part of a Power Management Integrated Circuit (PMIC).

The battery 8289 may supply power to the components of the electronic apparatus 8201. The battery 8289 may include a rechargeable primary cell, a rechargeable secondary cell, and/or a fuel cell.

The communication module 8290 may support establishing a direct (wire) communication channel and/or a wireless communication channel between the electronic apparatus 8201 and another electronic apparatus (the electronic apparatuses 8202 and 8204, the server 8208, etc.) and performing communication through the established communication channel. The communication module 8290 may be operated independently of the processor 8220 (the application processor, etc.) and may include one or more communication processors that support direct communication and/or wireless communication. The communication module 8290 may include a wireless communication module 8292 (a cellular communication module, a near-field communication module, a global navigation satellite system (GNSS) communication module, etc.) and/or a wired communication module 8294 (a local area network (LAN) communication module, a power line communication module, etc.). Among these communication modules, the corresponding communication module may communicate with another electronic apparatus through the first network 8298 (the near-field communication network such as bluetooth, Wifi Direct, or infrared data association (IrDA)) or a second network 8299 (the far-field communication network such as a cellular network, the Internet, or a computer network (a local area network (LAN), a wide area network (WAN), etc.)). Various types of communication modules may be integrated into one component (a single chip, etc.), or may be implemented with a plurality of components separate from each other (plural chips). The wireless communication module 8292 may check and authenticate the electronic apparatus 8201 in the communication network such as the first network 8298 and/or the second network 8299 using the subscriber information stored in the subscriber identity module 8296 (International mobile subscriber identifier (IMSI), etc.).

The antenna module 8297 may transmit a signal and/or power to the outside (another electronic apparatus, etc.) or receive the signal and/or power from the outside. An antenna may include a radiator consisting of a conductive pattern formed on a substrate (a PCB, etc.). The antenna module 8297 may include one or a plurality of antennas. When a plurality of antennas are included, the communication module 8290 may select an antenna suitable for the communication method used in the communication network such as the first network 8298 and/or the second network 8299 may be selected among the plurality of antennas. Through the selected antenna, a signal and/or power may be transmitted or received between the communication module 8290 and another device. In addition to the antenna, other components (RFIC, etc.) may be included as part of the antenna module 8297.

Some of the components may be linked to each other through communication methods between surrounding apparatuses (buses, general purpose input and output (GPIO), serial peripheral interface (SPI), mobile industry processor interface (MIPI), etc.) and may interchange signals (commands, data, etc.)

Commands or data may be transmitted or received between the electronic apparatus 8201 and the electronic apparatus 8204 external thereto through the server 8208 connected to the second network 8299. The other electronic apparatuses 8202 and 8204 may be the same as or different from the electronic apparatus 8201. All or a part of the operations executed in the electronic apparatus 8201 may be executed in one or more of the other electronic apparatuses, that is, the electronic apparatus 8202, the electronic apparatus 8204, and the server 8208. For example, when the electronic apparatus 8201 is required to perform a function or a service, instead of executing the function or service on its own, the electronic apparatus 8201 may request the one or more other electronic apparatuses to perform some or all of the function or service. One or more other electronic apparatuses that received the request may execute an additional function or service related to the request, and transmit the result of the execution to the electronic apparatus 8201. For this purpose, cloud computing, distributed computing, and/or client-server computing technology may be used.

The display device according to an example embodiment may also be applied to mobile apparatuses, vehicles, head-up displays, augmented/virtual reality devices, large scale signage, wearable displays, rollable TVs, and stretchable displays, and the like.

The display transferring structure includes a transferring substrate in which the micro semiconductor chips may be easily aligned, and a plurality of micro semiconductor chips may be appropriately aligned in the correct position within a large area.

Various types of display devices such as a large-area display device may be easily implemented using the display transferring structure according to example embodiment of the disclosure.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

**Claims**

1. A display transferring apparatus comprising:

    a transferring substrate comprising a mold including a plurality of recesses, and a plurality of protrusions provided on an outer surface of the mold, the outer surface being connected to the plurality of recesses; and
    a plurality of micro semiconductor chips respectively provided in the plurality of recesses.

2. The display transferring apparatus of claim 1, wherein a width of each of the plurality of protrusions is less than a width of each of the plurality of micro semiconductor chips.

3. The display transferring apparatus of claim 1 or 2, wherein a space between adjacent protrusions among the plurality of protrusions is less than a width of each of the plurality of micro semiconductor chips.

4. The display transferring apparatus of claim 3,

    wherein the space between adjacent protrusions among the plurality of protrusions, which is defined as s, satisfies a condition:

$$s \leq (w1-w2)/2,$$

    wherein, w1 is the width of each micro semiconductor chip and w2 is the width of each of the protrusions, respectively.

5. The display transferring apparatus of any preceding claim,
wherein the plurality of protrusions comprise a different material from a material of the mold.

6. The display transferring apparatus of claim 5, wherein the plurality of protrusions comprise a metal material.

7. The display transferring apparatus of any preceding claim,
wherein areas between the plurality of protrusions are filled with a first material that is different from a second material of the plurality of protrusions.

8. The display transferring apparatus of any of claims 1, 2, 3, 4 or 7, wherein the protrusions and the mold include a same material and are integrated.

9. The display transferring apparatus of claim 8,

wherein the protrusions are defined by a plurality of concave patterns recessed from the outer surface of the mold.

10. The display transferring apparatus of claim 9, wherein depths of the concave patterns are the same as depths of the recesses.

11. The display transferring apparatus of any preceding claim,
wherein the plurality of protrusions are formed by roughing the outer surface of the mold.

12. The display transferring apparatus of any preceding claim, further comprising a driving circuit configured to drive the micro semiconductor chips.

13. The display transferring apparatus of claim 12, wherein the driving circuit is provided inside the transferring substrate.

14. The display transferring apparatus of claim 13, further comprising a circuit board provided under the transferring substrate and including the driving circuit.

15. A display device comprising:

a display transferring apparatus according to any preceding claim;a driving circuit configured to drive the plurality of micro semiconductor chips; and
a color conversion layer provided on the transferring substrate.

# FIG. 1

# FIG. 2

## FIG. 3

$$s \ (s \leq s_c)$$

## FIG. 4

$$s \ (s > s_c)$$

# FIG. 5

## FIG. 6

## FIG. 7

# FIG. 8

101

121  121
122    122        HO
              148 149      140      110a

131                                              110

145  146  147

# FIG. 9

102

123  124  123  124     HO
                    148 149      140

132                                              110

145  146  147

# FIG. 10

103

HO
126              148 149      140

133                                              110

145  146  147

# FIG. 11

# FIG. 12

# FIG. 13

# FIG. 14

# FIG. 15

1000

1400
1310 — 1300R  1300G  1300B — 1300
1200
1110 — 1100R  1100G  1100B — 1100
1005
106
120
110
160

HO    190  145  146  147  140

# FIG. 16

8200

8201

**ELECTRONIC APPARATUS**

8230

MEMORY 8232

VOLATILE MEMORY

8234

NON-VOLATILE MEMORY

BUILT-IN MEMORY — 8236

EXTERNAL MEMORY — 8238

8240

PROGRAM 8246

APPLICATION

8244

MIDDLEWARE

8242

OPERATING SYSTEM

8250

INPUT DEVICE

8255

SOUND OUTPUT DEVICE

8260

DISPLAY DEVICE

8289

BATTERY

8220

PROCESSOR

8221

MAIN PROCESSOR

8223

AUXILIARY PROCESSOR

8288

POWER MANAGEMENT MODULE

8290

COMMUNICATION MODULE

WIRELESS COMMUNICATION MODULE — 8292

WIRED COMMUNICATION MODULE — 8294

8296

SUBSCRIBER IDENTITY MODULE

8297

ANTENNA MODULE

8270

AUDIO MODULE

8279

HAPTIC MODULE

8276

SENSOR MODULE

8280

CAMERA MODULE

8277

INTERFACE

8278

CONNECTION TERMINAL

8299

NETWORK

8298

8204

ELECTRONIC APPARATUS

8202

ELECTRONIC APPARATUS

8208

SERVER

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2019/192041 A1 (SHENZHEN SHOWHO TECH CO LTD [CN]) 10 October 2019 (2019-10-10) * paragraph [0009]; figure 1 * | 1-6,8, 12,13,15 | INV. H01L25/075 |
| X | KR 2014 0134038 A (SEOUL SEMICONDUCTOR CO LTD [KR]) 21 November 2014 (2014-11-21) * paragraph [0003]; figure 6 * | 1,8, 12-14 | |
| Y | | 11 | |
| X | US 10 230 020 B2 (SHARP LABORATORIES AMERICA INC [US]; ELUX INC [US]) 12 March 2019 (2019-03-12) * column 9, lines 20-65; figures 4-6 * | 1-4, 7-10,15 | |
| Y | US 2004/241894 A1 (NAGAI YOSHIFUMI [JP] ET AL) 2 December 2004 (2004-12-02) * figure 2 * | 11 | |

**TECHNICAL FIELDS SEARCHED (IPC)**

H01L

The present search report has been drawn up for all claims

| Place of search | Date of completion of the search | Examiner |
|---|---|---|
| The Hague | 27 May 2022 | Müller-Kirsch, Lutz |

EPO FORM 1503 03.82 (P04C01)

**EP 4 040 485 A1**

## ANNEX TO THE EUROPEAN SEARCH REPORT
## ON EUROPEAN PATENT APPLICATION NO.

EP 21 21 3438

This annex lists the patent family members relating to the patent documents cited in the above-mentioned European search report.
The members are as contained in the European Patent Office EDP file on
The European Patent Office is in no way liable for these particulars which are merely given for the purpose of information.

27-05-2022

| Patent document cited in search report | | Publication date | Patent family member(s) | | Publication date |
|---|---|---|---|---|---|
| WO 2019192041 | A1 | 10-10-2019 | CN | 108346381 A | 31-07-2018 |
| | | | WO | 2019192041 A1 | 10-10-2019 |
| KR 20140134038 | A | 21-11-2014 | NONE | | |
| US 10230020 | B2 | 12-03-2019 | CN | 108028169 A | 11-05-2018 |
| | | | EP | 3314631 A1 | 02-05-2018 |
| | | | JP | 6538886 B2 | 03-07-2019 |
| | | | JP | 2018528601 A | 27-09-2018 |
| | | | KR | 20180020239 A | 27-02-2018 |
| | | | KR | 20190111151 A | 01-10-2019 |
| | | | US | 2016380158 A1 | 29-12-2016 |
| | | | US | 2017317242 A1 | 02-11-2017 |
| | | | US | 2019181304 A1 | 13-06-2019 |
| | | | US | 2021151633 A1 | 20-05-2021 |
| | | | WO | 2016209792 A1 | 29-12-2016 |
| US 2004241894 | A1 | 02-12-2004 | CA | 2353326 A1 | 21-01-2002 |
| | | | EP | 1174931 A2 | 23-01-2002 |
| | | | EP | 2244245 A2 | 27-10-2010 |
| | | | JP | 4066620 B2 | 26-03-2008 |
| | | | JP | 2003086846 A | 20-03-2003 |
| | | | US | 2002039001 A1 | 04-04-2002 |
| | | | US | 2004046222 A1 | 11-03-2004 |
| | | | US | 2004241894 A1 | 02-12-2004 |
| | | | US | 2006234409 A1 | 19-10-2006 |

EPO FORM P0459

For more details about this annex : see Official Journal of the European Patent Office, No. 12/82

22